# EUROPEAN PATENT APPLICATION

(11) **EP 3 001 424 A1**
(43) Date of publication of application: **30.03.2016**
(21) Application number: 14186692.1
(22) Date of filing: 26.09.2014
(51) Int. Cl.: G11C 13/00

(54) **Operation method of resistive random access memory cell**

(71) Applicant: Winbond Electronics Corp., Taichung City, Taiwan. (TW)
(72) Inventor: Ho, Chia-Hua, Taichung City (TW); Liao, Shao-Ching, Miaoli County 366 (TW); Wang, Ping-Kun, Taichung City 429 (TW); Lin, Meng-Hung, Taichung City 420 (TW)
(74) Representative: Chamberlain, Alan James

(57) **Abstract**

An operation method of a resistive random access memory (RRAM) cell is provided, wherein the RRAM cell includes a variable impedance element and a switch element connected in series. The operation method includes the following steps. When the switch element is turned-on, a writing signal is provided to the variable impedance element to set an impedance of the variable impedance element. In a first period, the writing signal is set to a first writing voltage level to transmit a first electrical energy to the variable impedance element. In a second period, a second electrical energy is transmitted to the variable impedance element by the writing signal. The second period is subsequent to the first period, the first electrical energy and the second electrical energy are greater than zero, and the second electrical energy is smaller than the first electrical energy.

## Description

### BACKGROUND OF THE INVENTION

### Field of the Invention

The invention relates to an operation method, and more particularly, relates to an operation method of a resistive random access memory cell.

### Description of Related Art

Non-volatile memory is characterized by maintaining the stored data even when the power is off, and has thus become a memory element required in many electronic products for maintaining normal operations. Currently, a resistive random access memory (RRAM) is a non-volatile memory under positive developments in the industry, which has advantages including low writing operation voltage, short writing erase time, long memorizing time, non-destructive read, multi-state memory, simple structure, smaller required area and so on, and also has great potential for future applications in the fields of personal computers and electronic equipments.

However, various issues still need to be solved for the resistive random access memory, such as the issue in which a filament path in a variable impedance element may be narrowed or disappeared due to an influence of high temperature to affect writing of bits. Accordingly, how to reduce the influence of high temperature on the filament path in the variable impedance element has become an important task in designing the resistive random access memory.

### SUMMARY OF THE INVENTION

The invention is directed to an operation method of a resistive random access memory cell capable of providing longer moving time for moving ions in the variable impedance element to reduce a proportion of the moving ions remained in an active layer, so as to reduce a possibility of loss ions to jump back on the filament path due to activation by high temperature. Accordingly, the influence of high temperature on the filament path in the variable impedance element may be reduced.

In an operation method of a resistive random access memory cell of the invention, the resistive random access memory cell includes a variable impedance element and a switch element connected in series. The operation method includes the following steps. When the switch element is turned-on, a writing signal is provided to the variable impedance element to set an impedance of the variable impedance element. In a first period, the writing signal is set to a first writing voltage level to transmit a first electrical energy to the variable impedance element. In a second period, a second electrical energy is transmitted to the variable impedance element by the writing signal, wherein the second period is subsequent to the first period, the first electrical energy and the second electrical energy are greater than zero, and the second electrical energy is smaller than the first electrical energy.

Based on above, in the operation method of the resistive random access memory cell according to the embodiments of the invention, after the period for transmitting the writing voltage, the writing signal can still transmit energies to the variable impedance element to maintain a thermal chemical effect for the variable impedance element, and thereby extend a moving time of oxygen ions in the variable impedance element. Accordingly, the moving oxygen ions move away from the filament path in the variable impedance element, and thus the influence of high temperature on the filament path in the variable impedance element may be reduced.

To make the above features and advantages of the disclosure more comprehensible, several embodiments accompanied with drawings are described in detail as follows.

### BRIEF DESCRIPTION OF THE DRAWINGS

FIG. 1 is a schematic diagram illustrating a resistive random access memory cell according to an embodiment of the invention.
FIG. 2 is a schematic diagram illustrating a driving waveform of a writing signal according to a first embodiment of the invention.
FIG. 3 is a schematic diagram illustrating a driving waveform of a writing signal according to a second embodiment of the invention.
FIG. 4A and FIG. 4B are schematic diagrams respectively illustrating writing effects from the writing signals according to an embodiment of the invention.
FIG. 5 is a schematic diagram illustrating a driving waveform of a writing signal according to a third embodiment of the invention.
FIG. 6 is a schematic diagram illustrating a driving waveform of a writing signal according to a fourth embodiment of the invention.
FIG. 7 is a schematic diagram illustrating a driving waveform of a writing signal according to a fifth embodiment of the invention.

### DESCRIPTION OF THE EMBODIMENTS

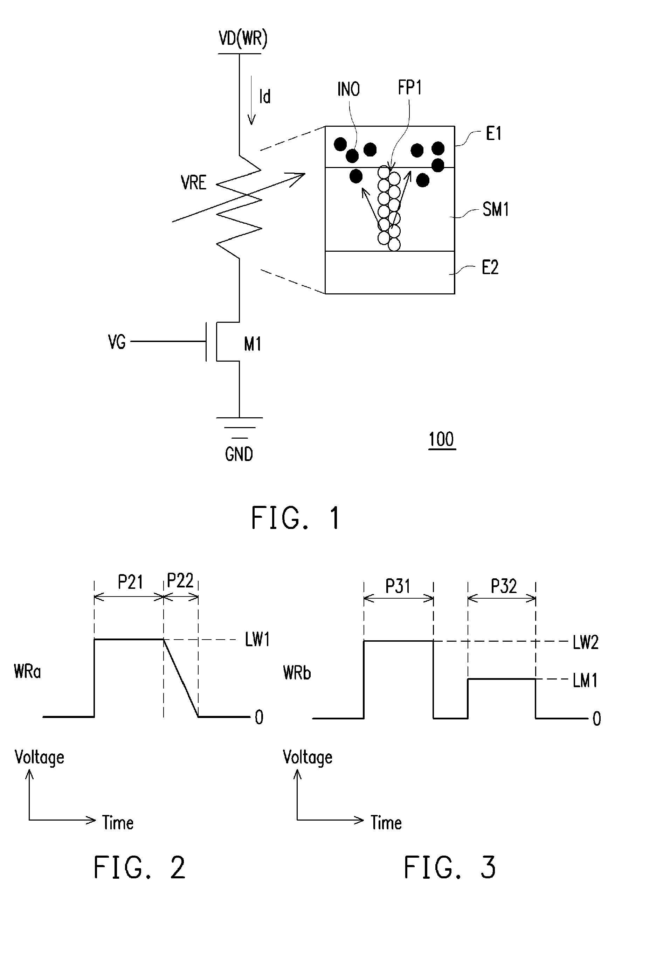

FIG. 1 is a schematic diagram illustrating a resistive random access memory cell according to an embodiment of the invention. Referring to FIG. 1, in the present embodiment, a resistive random access memory cell 100 includes, for example, a variable impedance element VRE and a transistor M1 (i.e., a switch element), wherein the variable impedance element VRE may be a voltage control switch element or a current control switch element. The variable impedance element VRE is coupled between a drain voltage VD and a drain of the transistor M1. That is, the variable impedance element VRE is connected to the transistor M1 in series, a gate of the transistor receives a gate control voltage VG, and a source of the transistor M1receives a ground voltage GND. Further, the variable impedance element VRE has a first electrode E1, a switching medium SM1 and a second electrode E2, wherein a material of the first electrode E1 is Ti for example, a material of the switching medium SM1 is HfO2 for example, and a material of the second electrode E2 is TiN for example.

When the variable impedance element VRE is set, the gate control voltage VG is provided to the gate of the transistor M1 to turn on the transistor M1, and the drain voltage VD with positive polarity (i.e., a writing signal WR) is provided to the variable impedance element VRE, so that oxygen ions INO in the switching medium SM1 are moved to the first electrode E1 under influence of the drain voltage VD. In this case, oxygen vacancies are formed in the switching medium SM1 to form a filament path FP1 and thereby generate a drain current Id, and the drain current Id may flow through the filament path FP1 formed in the switching medium SM1. Due to generation of the filament path FP1, an impedance of the switching medium SM1 is significantly decreased. That is, the switching medium SM1 is in a low impedance state indicated by the logic level "1".

On the other hand, when the variable impedance element VRE is reset, the gate control voltage VG is also provided to the gate of the transistor M1 to turn on the transistor M1. However, the drain voltage VD with negative polarity is provided to the variable impedance element VRE instead, so that the oxygen ions INO in the first electrode E1 are moved back to the switching medium SM1 under influence of the drain voltage VD and the drain current Id. In this case, the oxygen vacancies in the switching medium SM1 are disappeared, so that the filament path FP1 is also disappeared accordingly. Because the filament path FP1 is disappeared, the impedance of the switching medium SM1 is significantly increased. That is, the switching medium SM1 is in a high impedance state indicated by the logic level "0".

In addition, when the variable impedance element VRE is the voltage control switch element, the gate control voltage VG may be higher than the drain voltage VD. When the variable impedance element VRE is the current control switch element, the gate control voltage VG may be lower than the drain voltage VD.

FIG. 2 is a schematic diagram illustrating a driving waveform of a writing signal according to a first embodiment of the invention. Referring to FIG. 1 and FIG. 2, in which the same or similar elements are indicated by the same or similar reference numbers. In the present embodiment, a writing signal WRa is configured to set the variable impedance element VRE. That is, when the transistor M1 is turned-on, the writing signal WRa is provided to the variable impedance element VRE to set an impedance of the variable impedance element VRE.

In a period P21 (corresponding to a first period), the writing signal WRa is set to a writing voltage level LW1 (corresponding to a first writing voltage level), so as to trigger the oxygen ions INO in the switching medium SM1 to start moving and thereby form the filament path FP1 in the switching medium VRE. Next, in a period P22 (corresponding to a second period), the writing signal WRa is set to be gradually decreased from the writing voltage level LW1 to the ground voltage (i.e., the voltage level 0), so as to extend a moving time for the oxygen ions INO in the switching medium SM1 to increase formations of the filament path FP1. Therein, it is assumed that a decrement period for the writing voltage level LW1 to be gradually decreased to the ground voltage is equal to the period P22.

In other words, in the period P21, the writing signal WRa is set to the writing voltage level LW1 to transmit a first electrical energy being greater (corresponding to a product of the writing voltage level LW1 and a time length of the period P21) to the variable impedance element VRE, so as to trigger the switching medium SM1 to form the filament path FP1. Furthermore, in the period P22 subsequent to the period P21, a second electrical energy (corresponding to a half of a product of the writing voltage level LW1 and a time length of the period P22) being smaller than the first electrical energy is transmitted to the variable impedance element VRE by the writing signal WRa.

In the present embodiment, the time length of the period P22 is equal to a half the time length of the period P21. However, in other embodiments, the time length of the period P22 may equal to 0.5 to 3 times the time length of the period P21, but the invention is not limited thereto.

FIG. 3 is a schematic diagram illustrating a driving waveform of a writing signal according to a second embodiment of the invention. Referring to FIG. 1 and FIG. 3, in which the same or similar elements are indicated by the same or similar reference numbers. In the present embodiment, a writing signal WRb is also configured to set the variable impedance element VRE. That is, when the transistor M1 is turned-on, the writing signal WRb is provided to the variable impedance element VRE to set the impedance of the variable impedance element VRE.

In a period P31 (corresponding to the first period), the writing signal WRb is set to a writing voltage level LW2 (corresponding to the first writing voltage level), namely, a pulse with the voltage level being the writing voltage level LW2 is formed, so as to trigger the oxygen ions INO in the switching medium SM1 to start moving and thereby form the filament path in the switching medium VRE. Next, in a period P32 (corresponding to the second period), the writing signal WRb is set to a maintaining voltage level LM1 (corresponding to a first maintaining voltage level), namely, a pulse with the voltage level being the maintaining voltage level LM1 is formed, so as to extend the moving time for the oxygen ions INO in the switching medium SM1 to increase the formations of filament path FP1.

In other words, in the period P31, the writing signal WRb is set to the writing voltage level LW2 to transmit the first electrical energy being greater (corresponding to a product of the writing voltage level LW2 and a time length of the period P31) to the variable impedance element VRE, so as to trigger the switching medium SM1 to form the filament path FP1. Furthermore, in the period P32 subsequent to the period P31, the second electrical energy (corresponding to a product of the maintaining voltage level LM1 and a time length of the period P32) being smaller than the first electrical energy is transmitted to the variable impedance element VRE by the writing signal WRb.

In the present embodiment, the maintaining voltage level LM1 is equal to a half (i.e., 1/2 times) the writing voltage level LW2, the period P31 is not adjacent to the period P32, and the time length of the period P32 is equal to the time length of the period P31. However, in other embodiments, the maintaining voltage level LM1 may equal to 1/3 to 2/3 times the writing voltage level LW2, the period P31 may be adjacent to the period P32, and the time length of the period P32 is equal to 0.5 to 3 times the time length of the period P31. However, the embodiment of the invention is not limited thereto. Further, an interval between the periods P31 and P32 may be set to be smaller than the time length of the period P31, but this is decided according to test environments and the invention is not limited thereto.

In the first and second embodiments of the invention, because a thermal chemical effect may be generated when the writing signal WR is set to the writing voltage level (e.g., LW1, LW2) in the first period (corresponding to the period P21, the period P31), the formed filament path FP1 may be narrowed or disappeared due to an influence of high temperature. Accordingly, the invention sets the writing signal WR to be gradually decreased from the writing voltage level (e.g., LW1, LW2) to the ground voltage or to the maintaining voltage level (e.g., LM1) smaller than the writing voltage level (e.g., LW1, LW2) in the second period (corresponding to the period P22, the period P32), such that the moving time of the oxygen ions INO in the switching medium SM1 may be extended to increase the formations of the filament path FP1 while reducing the influence of high temperature generated by the thermal chemical effect on the filament path FP1.

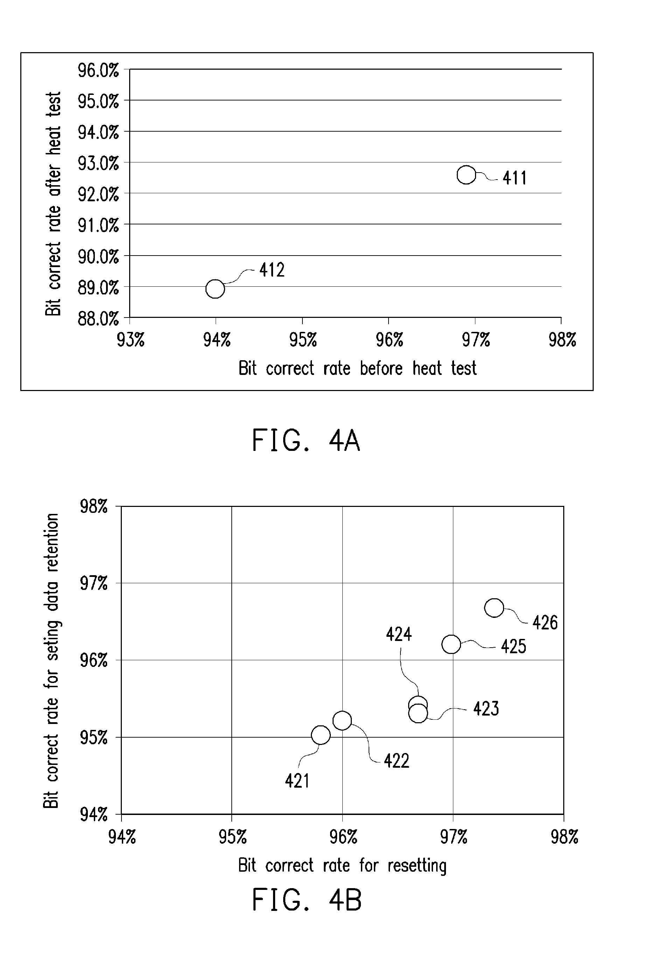

FIG. 4A and FIG. 4B are schematic diagrams respectively illustrating writing effects from the writing signals according to an embodiment of the invention. FIG. 4A illustrates an example of the variable impedance element VRE for voltage control switching, and FIG. 4B illustrate an example of the variable impedance element VRE for current control switching. Referring to FIG. 1 to FIG. 3 and FIG. 4A, in which a coordinate point 411 is configured to indicate a correspondence relationship of bit correct rates before and after a heat test with respect to a writing effect from the writing signal WR including only the first period (e.g., P21, P31), and a coordinate point 412 is configured to indicate a correspondence relationship of bit correct rates before and after the heat test with respect to a writing effect from writing signal WR including the first period (e.g., P21, P31) and the second period (e.g., P22, P32). Further, afore-said heat test may be a baking in 175°C for 24 hours.

Referring to FIG. 1 to FIG. 3 and FIG. 4B, in which a coordinate point 421 is configured to indicate a writing effect from the writing signal WR including only the first period (i.e., P21, P31) being used for setting and resetting, and coordinate points 422 to 426 are configured to indicate writing effects from the writing signal WR including both the first period (i.e., P21, P31) and the second period (i.e., P22, P32) for setting and resetting. Afore-said settings are performed by using a current with more than 10µA; afore-said resettings are performed by using a current with more than 5µA; and the writing effects are effects after the heat test (e.g., the baking in 175°C for 24 hours).

Furthermore, the coordinate points 422 to 426 respectively indicate the writing effects from combinations of the first periods (e.g., P21, P31) with different time lengths, the second periods (e.g., P22, P32) with different time lengths, different writing voltage levels (e.g., LW1, LW2) and different maintaining voltage levels (e.g., LM1).

As shown by FIG. 4A and FIG. 4B, the embodiment of the invention is capable of providing higher bit correct rate. That is, based on the embodiment of the invention, the influence of high temperature on the filament path FP1 formed in the switching medium SM1 is reduced.

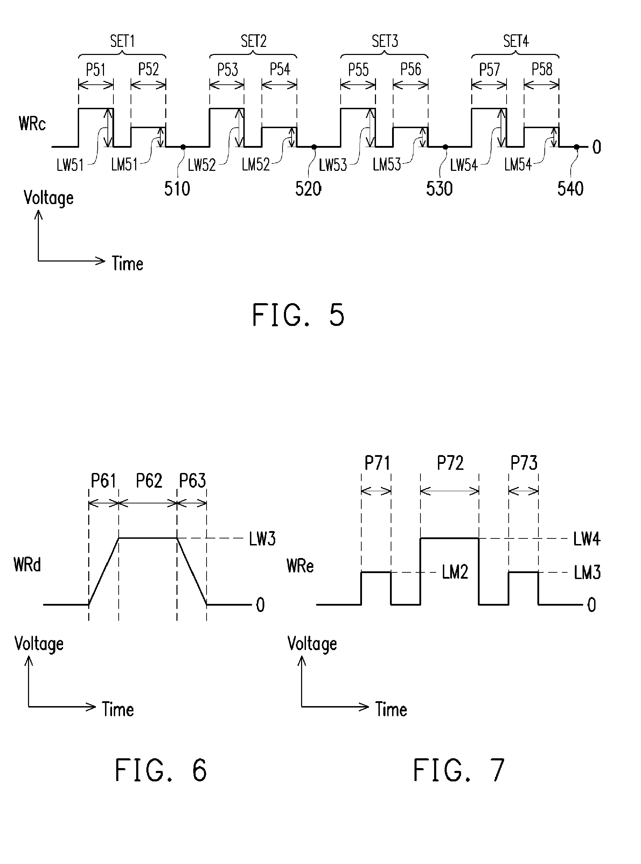

FIG. 5 is a schematic diagram illustrating a driving waveform of a writing signal according to a third embodiment of the invention. Referring to FIG. 1, FIG. 3 and FIG. 5, in which the same or similar elements are indicated by the same or similar reference numbers. In the present embodiment, a writing signal WRc includes a period P51 (corresponding to the first period), a period P52 (corresponding to the second period), periods P53, P55 and P57 (corresponding to a plurality of third periods), periods P54, P56 and P58 (corresponding to a plurality of fourth periods), and includes four read time points 510, 520, 530 and 540. Among them, two adjacent periods may considered as one writing set (e.g., SET1 to SET4), and actions of each writing set may refer to FIG. 3, which are not repeated hereinafter.

In the periods P51, P53, P55 and P57 (corresponding to the first period and the third periods), the writing signal WRc is set to voltage levels LW51 and LW52 to LW54 (corresponding to the first writing voltage level and a plurality of second writing voltage levels) in sequence to transmit a plurality of electrical energies (corresponding to the first electrical energy and a plurality of third electrical energies) in sequence to the variable impedance element VRE. In the periods P52, P54, P56 and P58 (corresponding to the second period and the fourth periods), the writing signal WRc is set to maintaining voltage levels LM51 and LM52 to LM54 (corresponding to the first maintaining voltage level and a plurality of second maintaining voltage levels) in sequence to transmit a plurality of electrical energies (corresponding to the second electrical energy and a plurality of fourth electrical energies) in sequence to the variable impedance element VRE, wherein the periods P52, P54, P56 and P58 are subsequent to the periods P51, P53, P55 and P56, respectively. Further, the electrical energy transmitted by the writing signal WRc in the period P52 is smaller than the electrical energy transmitted by the writing signal WRc in the period P51, and the electrical energies transmitted by the writing signal WRc in the periods P54, P56 and P58 are smaller than the electrical energies transmitted by the writing signal WRc in the periods P53, P55 and P57.

More specifically, after a writing process is performed by using the writing set SET1, a writing verification is performed at the read time point 510. If the verification is correct, it is determined that the resistive random access memory cell 100 is available, and the writing process is no longer performed thereto; and if the verification is incorrect, a writing process is performed by using the writing set SET2, and the writing verification is performed at the read time point 520. If the verification is correct, it is determined that the resistive random access memory cell 100 is available, and the writing process is no longer performed thereto; and if the verification is incorrect, a writing process is performed by using the writing set SET3, and the writing verification is performed at the read time point 530. If the verification is correct, it is determined that the resistive random access memory cell 100 is available, and the writing process is no longer performed thereto; and if the verification is incorrect, a writing process is performed by using the writing set SET4, and the writing verification is performed at the read time point 540. If the verification is correct, it is determined that the resistive random access memory cell 100 is available, and the writing process is no longer performed thereto; and If the verification is incorrect, it is determined that the resistive random access memory cell 100 is unavailable.

In an embodiment of the invention, the writing voltage levels LW51 to LW54 may set to be completely identical to one another. However, in other embodiments, the writing voltage levels LW51 to LW54 may set to be completely different from one another (e.g., the writing voltage levels LW51 to LW54 may set to be increased in sequence).

In an embodiment of the invention, the maintaining voltage levels LM51 to LM54 may be set to completely identical to one another (i.e., the electrical energies transmitted by the writing signal WRc in the periods P52, P54, P56 and P58 are completely identical to one another). However, in other embodiments, the maintaining voltage levels LM51 to LM54 may be set to be completely different from another (i.e., the electrical energies transmitted by the writing signal WRc in the periods P52, P54, P56 and P58 are completely different from another). For example, the voltage levels LM51 to LM54 may be set to be increased in sequence, so that the electrical energies transmitted by the writing signal WRc in the periods P52, P54, P56 and P58 may also be increased in sequence.

In an embodiment of the invention, time lengths of the periods P51, P53, P55 and P57 may be set be completely identical to one another. However, in other embodiments, the time lengths of the periods P51, P53, P55 and P57 may set to be completely different from one another (e.g., the time lengths of the periods P51, P53, P55 and P57 may set to be increased in sequence).

In an embodiment of the invention, the time lengths of the periods P52, P54, P56 and P58 may be set to be completely identical to one another. However, in other embodiments, the time lengths of the periods P52, P54, P56 and P58 may set to be completely different from one another (e.g., the time lengths of the periods P52, P54, P56 and P58 may set to be increased in sequence).

In the present embodiment, a waveform of each of the writing sets SET1 to SET4 is similar to the driving waveform shown in the embodiment of FIG. 3 (i.e., the waveform shown by the writing signal WRb). However, in other present embodiment, the waveform of each of the writing sets SET1 to SET4 is similar to the driving waveform shown in the embodiment of FIG. 2 (i.e., the waveform shown by the writing signal WRa), but the invention is not limited thereto.

FIG. 6 is a schematic diagram illustrating a driving waveform of a writing signal according to a fourth embodiment of the invention. Referring to FIG. 1, FIG. 2 and FIG. 6, in which the same or similar elements are indicated by the same or similar reference numbers. In the present embodiment, a waveform of a writing signal WRd in the periods P62 and P63 is similar to the waveform of the writing signal WRa in the periods P21 and P22, wherein a writing voltage level LW3 may be identical to or different from the writing voltage level LW1. However, the embodiment of the invention is not limited thereto. Further, a waveform of the writing signal WRd in the periods P61 to P63 may be considered as one writing set (e.g., SET1 to SET4).

In the present embodiment, the writing signal WRd further includes the period P61 (corresponding to a fifth period), and in the period P61, the writing signal WRd is set to be increased from the ground voltage (i.e., the voltage level 0) to the writing voltage level LW3 to transmit an electrical energy (corresponding to a fifth electrical energy) to the variable impedance element VRE. Among them, the electrical energy transmitted by the writing signal WRd in the period P61 (corresponding to a half a product of the writing voltage level LW3 and a time length of the period P61) is smaller than an electrical energy transmitted by the writing signal WRd in the period P62 (corresponding to a product of the writing voltage level LW3 and a time length of the period P62).

FIG. 7 is a schematic diagram illustrating a driving waveform of a writing signal according to a fifth embodiment of the invention. Referring to FIG. 1, FIG. 3 and FIG. 7, in which the same or similar elements are indicated by the same or similar reference numbers. In the present embodiment, a waveform of a writing signal WRe in the periods P72 and P73 is similar to the waveform of the writing signal WRb in the periods P31 and P32, wherein a writing voltage level LW4 may be identical to or different from the writing voltage level LW2, and a maintaining voltage level LM3 may be identical to or different from the maintaining voltage level LM1. However, the embodiment of the invention is not limited thereto. Further, a waveform of the writing signal WRe in the periods P71 to P73 may be considered as one writing set (e.g., SET1 to SET4).

In the present embodiment, the writing signal WRe further includes the period P71 (corresponding to the fifth period), and in the period P71, the writing signal WRe is set to a maintaining voltage level LM2 to transmit the electrical energy (corresponding to the fifth electrical energy) to the variable impedance element VRE. Among them, the electrical energy transmitted by the writing signal WRe in the period P71 (corresponding to a product of the maintaining voltage level LM2 and a time length of the period P71) is smaller than an electrical energy transmitted by the writing signal WRe in the period P72 (corresponding to a product of the writing voltage level LW4 and a time length of the period P72).

In the present embodiment, the maintaining voltage level LM2 is equal to a half (1/2 times) the writing voltage level LW4, the period P71 is not adjacent to the period P72, and a time length of the period P71 is equal to the time length of the period P72. However, in other embodiments, the maintaining voltage level LM2 may equal to 1/3 to 2/3 times the writing voltage level LW4, the period P71 may be adjacent to the period P72, and the time length of the period P71 is equal to 0.5 to 3 times the time length of the period P72. However, the embodiment of the invention is not limited thereto. Further, an interval between the periods P71 and P72 may be set to be smaller than the time length of the period P72, but this is decided according to test environments and the invention is not limited thereto.

In summary, in the operation method of the resistive random access memory cell according to the embodiment of the invention, after the period for transmitting the writing voltage, the writing signal can still transmit energies to the variable impedance element to extend the moving time of the oxygen ions in the variable impedance element, so as to increase the formations of the filament path while reducing the influence of high temperature generated by the thermal chemical effect on the filament path.

## Claims

1. An operation method of a resistive random access memory cell (100), wherein the resistive random access memory cell (100) comprises a variable impedance element (VRE) and a switch element (M1) connected in series, and the operation method comprises:
when the switch element (M1) is turned-on, providing a writing signal (WR, WRa, WRb, WRc, WRd, WRe) to the variable impedance element (VRE) to set an impedance of the variable impedance element (VRE);
in a first period (P21, P31, P51, P62, P72), setting the writing signal (WR, WRa, WRb, WRc, WRd, WRe) to a first writing voltage level (LW1, LW2, LW51, LW3, LW4) to transmit a first electrical energy to the variable impedance element (VRE); and
in a second period (P22, P32, P52, P63, P73), transmitting a second electrical energy to the variable impedance element (VRE) by the writing signal (WR, WRa, WRb, WRc, WRd, WRe), wherein the second period (P22, P32, P52, P63, P73) is subsequent to the first period (P21, P31, P51, P62, P72), the first electrical energy and the second electrical energy are greater than zero, and the second electrical energy is smaller than the first electrical energy.

2. The operation method of the resistive random access memory cell (100) of claim 1, further comprising:
in the second period (P22, P63), setting the writing signal (WRa, WRd) to be gradually decreased from the first writing voltage level (LW1, LW3, LW4) to a ground voltage.

3. The operation method of the resistive random access memory cell (100) of claim 1, further comprising:
in the second period (P32, P52, P73), setting the writing signal (WRb, WRc, WRe) to a first maintaining voltage level (LM1, LM51, LM3).

4. The operation method of the resistive random access memory cell (100) of claim 3, wherein the first maintaining voltage level (LM1, LM51, LM3) is equal to 1/3 to 2/3 times the first writing voltage level (LW2, LW51, LW4).

5. The operation method of the resistive random access memory cell (100) of claim 1, wherein a time length of the second period (P22, P32, P52, P63, P73) is equal to 0.5 to 3 times a time length of the first period (P21, P31, P51, P62, P72).

6. The operation method of the resistive random access memory cell (100) of claim 1, further comprising:
in a plurality of third periods (P53, P55, P57), setting the writing signal (WRc) to a plurality of second writing voltage levels (LW52, LW53, LW54) in sequence to transmit a plurality of third electrical energies in sequence to the variable impedance element (VRE), wherein the third periods (P53, P55, P57) are subsequent to the second period (P52); and
in a plurality of fourth periods (P54, P56, P58), transmitting a plurality of fourth electrical energies in sequence to the variable impedance element (VRE) by the writing signal (WRc), wherein each of the fourth periods (P54, P56, P58) is subsequent to one of the third periods (P53, P55, P57), the third electrical energies and the fourth electrical energies are greater than zero, and each of the fourth electrical energies is smaller than the third electrical energy transmitted by the writing signal (WRc) in the corresponding third period (P53, P55, P57).

7. The operation method of the resistive random access memory cell (100) of claim 6, wherein the first writing voltage level (LW51) and the second writing voltage levels (LW52, LW53, LW54) are identical to each other.

8. The operation method of the resistive random access memory cell (100) of claim 6, wherein the first writing voltage level (LW51) and the second writing voltage levels (LW52, LW53, LW54) are different from each other.

9. The operation method of the resistive random access memory cell (100) of claim 8, wherein the first writing voltage level (LW51) and the second writing voltage levels (LW52, LW53, LW54) are increased in sequence.

10. The operation method of the resistive random access memory cell (100) of claim 6, wherein the second electrical energy and the fourth electrical energies are identical to each other.

11. The operation method of the resistive random access memory cell (100) of claim 6, wherein the second electrical energy and the fourth electrical energies are different from each other.

12. The operation method of the resistive random access memory cell (100) of claim 11, wherein the second electrical energy and the fourth electrical energies are increased in sequence.

13. The operation method of the resistive random access memory cell (100) of claim 6, wherein the time length of the first period and a time length of the third period are identical to each other.

14. The operation method of the resistive random access memory cell (100) of claim 6, wherein the time length of the first period (P51) and a time length of the third period (P53, P55, P57) are different from each other.

15. The operation method of the resistive random access memory cell (100) of claim 14, wherein the time length of the first period (P51) and the time length of the third period (P53, P55, P57) are increased in sequence.

## Amended claims

### Amended claims in accordance with Rule 137(2) EPC.

1. An operation method of a resistive random access memory cell (100), wherein the resistive random access memory cell (100) comprises a variable impedance element (VRE) and a switch element (M1) connected in series, wherein said variable impedance element (VRE) comprises first and second electrodes (E1, E2) and a switching medium (SM1) provided between said electrodes and the operation method comprises:
when the switch element (M1) is turned-on, providing a writing signal (WR, WRa, WRb, WRc, WRd, WRe) having a positive polarity voltage to the variable impedance element (VRE), ions being moved in said switching medium (SM1) under the influence of the writing signal, to reduce an impedance of the switching medium (SM1) of the variable impedance element (VRE);
in a first period (P21, P31, P51, P62, P72), setting the writing signal (WR, WRa, WRb, WRc, WRd, WRe) to a first writing voltage level (LW1, LW2, LW51, LW3, LW4) to transmit a first electrical energy to the variable impedance element (VRE); and
in a second period (P22, P32, P52, P63, P73), transmitting a second electrical energy to the variable impedance element (VRE) by the writing signal (WR, WRa, WRb, WRc, WRd, WRe), wherein the second period (P22, P32, P52, P63, P73) is subsequent to the first period (P21, P31, P51, P62, P72), the first electrical energy and the second electrical energy are greater than zero,
the method **characterised in that** the second electrical energy is smaller than the first electrical energy and the operation method further comprises:
in the second period (P22, P63), setting the writing signal (WRa, WRd) to be gradually decreased from the first writing voltage level (LW1, LW3, LW4) to a ground voltage.

2. The operation method of the resistive random access memory cell (100) of claim 1, wherein a time length of the second period (P22, P32, P52, P63, P73) is equal to 0.5 to 3 times a time length of the first period (P21, P31, P51, P62, P72).

3. The operation method of the resistive random access memory cell (100) of claim 1, further comprising:
in a plurality of third periods (P53, P55, P57), setting the writing signal (WRc) to a plurality of second writing voltage levels (LW52, LW53, LW54) in sequence to transmit a plurality of third electrical energies in sequence to the variable impedance element (VRE), wherein the third periods (P53, P55, P57) are subsequent to the second period (P52); and
in a plurality of fourth periods (P54, P56, P58), transmitting a plurality of fourth electrical energies in sequence to the variable impedance element (VRE) by the writing signal (WRc), wherein each of the fourth periods (P54, P56, P58) is subsequent to one of the third periods (P53, P55, P57), the third electrical energies and the fourth electrical energies are greater than zero, and each of the fourth electrical energies is smaller than the third electrical energy transmitted by the writing signal (WRc) in the corresponding third period (P53, P55, P57).

4. The operation method of the resistive random access memory cell (100) of claim 3, wherein the first writing voltage level (LW51) and the second writing voltage levels (LW52, LW53, LW54) are identical to each other.

5. The operation method of the resistive random access memory cell (100) of claim 3, wherein the first writing voltage level (LW51) and the second writing voltage levels (LW52, LW53, LW54) are different from each other.

6. The operation method of the resistive random access memory cell (100) of claim 5, wherein the first writing voltage level (LW51) and the second writing voltage levels (LW52, LW53, LW54) are increased in sequence.

7. The operation method of the resistive random access memory cell (100) of claim 3, wherein the second electrical energy and the fourth electrical energies are identical to each other.

8. The operation method of the resistive random access memory cell (100) of claim 3, wherein the second electrical energy and the fourth electrical energies are different from each other.

9. The operation method of the resistive random access memory cell (100) of claim 8, wherein the second electrical energy and the fourth electrical energies are increased in sequence.

10. The operation method of the resistive random access memory cell (100) of claim 3, wherein the time length of the first period and a time length of the third period are identical to each other.

11. The operation method of the resistive random access memory cell (100) of claim 3, wherein the time length of the first period (P51) and a time length of the third period (P53, P55, P57) are different from each other.

12. The operation method of the resistive random access memory cell (100) of claim 11, wherein the time length of the first period (P51) and the time length of the third period (P53, P55, P57) are increased in sequence.
